# EUROPEAN PATENT SPECIFICATION

(11) **EP 0 595 361 B1**
(45) Date of publication and mention of the grant of the patent: **10.03.1999**
(21) Application number: 93117627.5
(22) Date of filing: 29.10.1993
(51) Int. Cl.: G03F 7/004, G03F 7/039

(54) **Method of forming micropatterns with heat resistance**
Verfahren zur Herstellung von wärmebeständigen Mikrobildern
Procédé de réalisation de micro-images résistantes à la chaleur

(30) Priority: 30.10.1992 JP 292453/92
(43) Date of publication of application: 04.05.1994
(73) Proprietor: MATSUSHITA ELECTRIC INDUSTRIAL CO., LTD., Kadoma-shi, Osaka-fu, 571 (JP); WAKO PURE CHEMICAL INDUSTRIES, LTD, Chuo-ku Osaka (JP)
(72) Inventor: Katsuyama, Akiko, Osaka 570 (JP); Endo, Masayuki, Osaka 594 (JP); Sasago, Masaru, Osaka 573 (JP); Urano, Fumiyoshi, Saitama 352 (JP); Fujie, Hirotoshi, Saitama 350 (JP)
(74) Representative: Grünecker, Kinkeldey, Stockmair & Schwanhäusser Anwaltssozietät

(56) References cited:
- EP-A- 0 358 871
- CHEMICAL ABSTRACTS, vol. 111, no. 20, 13 November 1989 Columbus, Ohio, US; abstract no. 175487b, MYASHITA, S. ET AL: "radiation-sensitive novolak resin compositions for positive-working resists" XP002024178 & JP 00 190 250 A (JAPAN SYNTHETIC RUBBER CO., LTD.)
- CHEMICAL ABSTRACTS, vol. 118, no. 18, 3 May 1993 Columbus, Ohio, US; abstract no. 180075q, MAEHARA, H.: "resist pattern formation by radioactive ray proximity exposure" XP002024179 & JP 04 304 616 A (CANON K.K.)

## Description

### BACKGROUND OF THE INVENTION

The present invention relates to a method of forming micropatterns in the process of fabricating semiconductor chips and integrated-circuit devices.

In a conventional process of fabricating ICs or LSIs, patterns are generally formed by photolithography using an ultraviolet ray. With the miniaturization of semiconductor devices, a light source of a shorter wavelength has been used increasingly to radiate an ultraviolet ray.

As a suitable resist for photolithography using a light source of shorter wavelength, there have been developed chemical amplification resists which provide high sensitivity as well as high resolution (e.g., O. NALAMASU et. al., Proc. SPIE, Vol. 1262, P. 32 (1990)). The chemical amplification resist is a multi-component material containing a photo acid generator which produces an acid in response to the radiation of a radio-active ray and a compound which reacts with the acid. Among polymers which react with an acid, a compound of the structure shown in [Formula 1] is known. 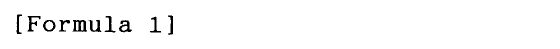 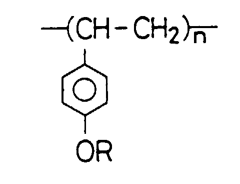 where R is an alkoxycarbonyl, alkyl, alkoxyalkyl, alkylsilyl, tetrahydropyranyl, alkoxycarbonylmethyl, or like group, which is easily decomposed by an acid. Such a chemical amplification resist contains, as its main component, a polymer which shows a low absorption index with respect to light in the range of a shorter wavelength, such as a derivative of polyvinyl phenol. Accordingly, the transparency of the chemical amplification resist is improved and the reaction of the resist proceeds through a chain reaction induced by an acid catalyst, resulting in high sensitivity and high resolution. Hence, the chemical amplification resist is considered as a promising material for forming micropatterns by utilizing a light source of a shorter wavelength.

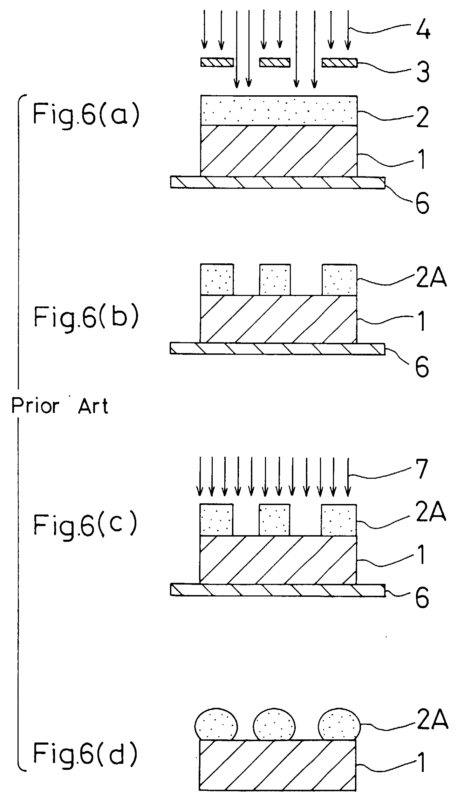

By way of example, a conventional method of forming micropatterns using a chemical amplification resist will be described below with reference to FIGS. 6(a) to 6(d).

First, a chemical amplification resist composed of the following materials is prepared.

| | |
|---|---|
| poly(p-tert-butoxycarbonyloxystyrene-p-hydroxystyrene) (weight-average molecular weight of approximately 9500, monomer unit ratio of approximately 1:1) | 6.0g |
| triphenylsulfonium hexafluorophosphate | 0.3g |
| diethylene glycol dimethyl ether | 13.7g |

Next, as shown in FIG. 6(a), the chemical amplification resist composed of the foregoing materials is applied dropwise to the surface of a semiconductor substrate 1, followed by spin coating. Subsequently, the semiconductor substrate 1 is subjected to 1-minute baking on a hot plate 6 at a temperature of 90° C, so as to form a resist film 2 with the thickness of 1.0 µm. Then, the resulting resist film 2 is irradiated with KrF eximer laser light 4 through a mask 3.

Thereafter, the resist film 2 is sequentially subjected to 1-minute baking on the hot plate 6 at a temperature of 100 ° C, as shown in FIG. 6(b), and to 1-minute development using an organic alkaline aqueous solution, thereby obtaining a resist pattern 2A.

Subsequently, as shown in FIG. 6(c), the entire surface of the resist pattern 2A is irradiated with a deep ultraviolet light 7 for 2 minutes, followed by a heat treatment on the hot plate 6, thereby raising the temperature of the semiconductor substrate 1 to, e.g., 160° C.

If a heat treatment is performed at a temperature not lower than, e.g., 160° C without the radiation of the deep ultraviolet light 7, the resulting resist pattern 2A is deformed because the derivative of polyvinyl phenol, which is contained in the chemical amplification resist as its main component, normally has a relatively low glass transition point not higher than 160° C, so that the pattern transition onto the semiconductor substrate 1 cannot be performed with high fidelity.

As described above, the method using the chemical amplification resist is effective in forming fine patterns due to the high transparency, sensitivity, and resolution of the chemical amplification resist. However, the chemical amplification resist has a disadvantage of poor heat resistance. To offset the disadvantage, there has been proposed the method of curing the resist pattern 2A, whereby a heat treatment is performed with the radiation of a deep ultraviolet light, as shown in FIG. 6(c).

However, the inventor of the present invention has discovered that, when the resist pattern 2A composed of a chemical amplification resist is subjected to a heat treatment with the radiation of a deep ultraviolet light, the polymer component of the chemical amplification resist is condensed and dissociated by the deep ultraviolet light, resulting in the reduction in size of the resist pattern 2A.

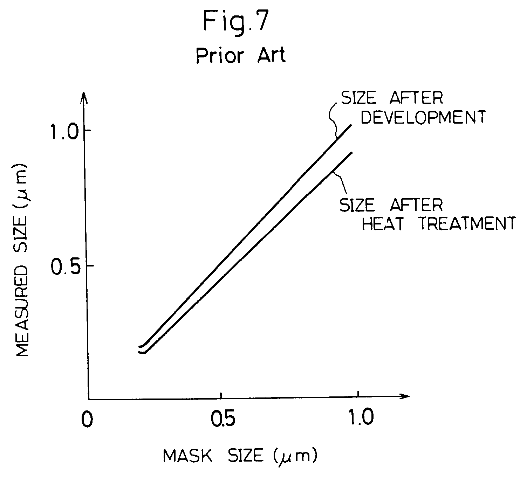

FIG. 7 is a graph showing the variation in size of the resist pattern 2A, which was formed according to the method of forming micropatterns mentioned above. The size measurement was conducted twice, after the development and after the heat treatment. As seen from FIG. 7, there is a 10% size variation between the resist pattern 2A after the development and the resist pattern 2A after the heat treatment.

Moreover, since the aforesaid variation in size varies depending on the dimensions of the resist pattern 2A, it is difficult to control the size of the resist pattern 2A with high precision.

### SUMMARY OF THE INVENTION

An object of the present invention, which was achieved in view of the foregoing, is to improve the heat resistance of the resist pattern without causing the variation in size of the resist pattern.

The present invention was achieved based on the discovery that, when the entire surface of the chemical amplification resist was irradiated with a radio-active ray, while maintaining the temperature of the semiconductor substrate in the range not higher than the glass transition point of the chemical amplification resist, the heat resistance of the resist pattern was improved without causing the variation in size of the resist pattern.

Concretely, a method of forming micropatterns with heat resistance comprises: a resist coating step of coating the surface of a semiconductor substrate with a chemical amplification resist composed of a radiosensitive material containing, as its main component, a polymer or monomolecular compound in which at least a part of phenol hydroxyl groups are substituted by protecting groups that are easily eliminated by the action of an acid; a resist-pattern forming step of forming a resist pattern from said chemical amplification resist by exposing said chemical amplification resist to light or irradiating said chemical amplification resist with a radio-active ray and by developing said chemical amplification resist; and a heat-resistance improving step of improving the heat resistance of said resist pattern by irradiating the entire surface of said resist pattern with a radio-active ray, while maintaining the temperature of said semiconductor substrate in the range not higher than the glass transition point of said chemical amplification resist, so as to eliminate the protecting groups contained in said chemical amplification resist.

Typical representatives of polymers in which at least a part of phenol hydroxyl groups are substituted by protecting groups that are easily eliminated by the action of an acid include poly(p-tert-butoxycarbonyl-oxystyrene), poly(p-tert-butoxystyrene), poly(p-tetrahydro-pyranyloxystyrene), poly(p-(1-ethoxyethoxy)styrene), poly(p- (1-methoxy-1-methylethoxy)styrene), poly(p-trimethylsilyl-oxystyrene), poly(p-tert-butoxycarbonyloxystyrene-p-hydroxy-styrene), poly(p-tert-butoxystyrene-p-hydroxystyrene), poly(p-tetrahydropyranyloxystyrene-p-hydroxystyrene), poly(p-(1-ethoxyethoxy)styrene-p-hydroxystyrene), poly(p-(1-methoxy-1-methylethoxy)styrene-p-hydroxystyrene), poly(p-trimethylsilyloxystyrene-p-hydroxystyrene), and poly(p-tert-butoxycarbonylmethoxystyrene-p-hydroxystyrene).

Typical representatives of monomolecular compounds in which all the phenol hydroxyl groups are substituted by protecting groups which are easily eliminated by the action of an acid include 2,2-bis(4-tetrahydropyranyloxyphenyl)propane, 2,2-bis(4-tert-butoxyphenyl)propane, 2,2-bis(4-tert-butoxycarbonyloxyphenyl)propane, 2,2-bis(4-(1-ethoxyethoxy)phenyl)propane, 3,4-dihydro-4-(2,4-di-(1-tetrahydropyranyloxy)phenyl)-7-(1-tetrahydropyranyloxy)-2,2,4-trimethyl-2H-1-benzopyran, 3,4-dihydro-4-(2,4-di-(1-tert-butoxy)phenyl)-7-(1-tert-butoxy)-2,2,4-trimethyl-2H-1-benzopyran and 3,4-dihydro-4-(2,4-di-(1-ethoxyethoxy)phenyl)-7-(1-ethoxyethoxy)-2,2,4-trimethyl-2H-1-1-benzopyran.

Even when a chemical amplification resist with a low glass transition point containing a derivative of polyvinyl phenol as its main polymer or a chemical amplification resist with poor heat resistance containing a derivative of bisphenol A or of trihydroxy-benzopyran as a dissolution inhibitor is used, the chemical amplification resist can be provided with sufficient heat resistance required to dry-etch the semiconductor substrate in accordance with the resist pattern. In particular, by irradiating the resist pattern with a radio-active ray, while maintaining the temperature of the semiconductor substrate in the range not higher than the glass transition point of the chemical amplification resist, the protecting groups, which were substituted for the hydroxyl groups of polyvinyl phenol serving as the skeleton of the main polymer or the hydroxyl groups of bisphenol A or trihydroxybenzopyran serving as the dissolution inhibitor and hence caused the deterioration of heat resistance, are eliminated in accordance with the following [Formula 2] and [Formula 3] without polymerizing the main polymer or dissolution inhibitor. Consequently, it becomes possible to replace a derivative of polyvinyl phenol by polyvinyl phenol with a higher glass transition point or to replace a derivative of bisphenol A or of trihydroxybenzopyran by bisphenol A or trihydroxybenzopyran with superior heat resistance.

The following [Formula 2] and [Formula 3] show the formation of protons from the photo acid generator contained in a chemical amplification resist, which was induced by the radiation of a radio-active ray, and the elimination of the protecting groups of the polymer or dissolution inhibitor by the resulting protons.

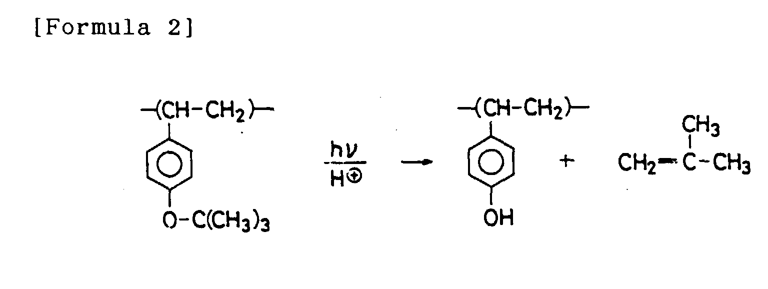

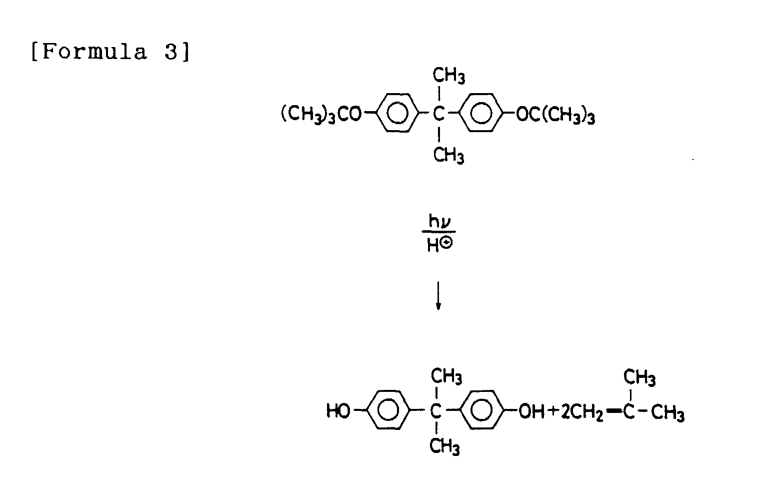

With the method of forming micropatterns according to the present invention, the chemical amplification resist is not easily cured, and therefore, the reduction in volume of the resist pattern which accompanies the curing of the chemical amplification resist seldom occurs, so that the variation in size can be minimized. Moreover, it becomes possible to form micropatterns with heat resistance which can sufficiently withstand dry etching at high temperature. Furthermore, since the heat treatment for curing the resist pattern is not required, it is not necessary to radiate a radio-active ray with high power at high temperature, either, thereby improving throughput.

With the method of forming micropatterns according to the present invention, fine resist patterns with high fidelity and excellent heat resistance can easily be formed, so that it can greatly contribute to the fabrication of extremely-high-density integrated circuits.

In the method of forming micropatterns according to the present invention, said heat-resistance improving step may be for improving the heat resistance of said resist pattern by irradiating the entire surface of said resist pattern with a radio-active ray, while maintaining the temperature of said semiconductor substrate in the range not higher than the glass transition point of said chemical amplification resist, and by heating said semiconductor substrate.

Thus, through the heating process of the semiconductor substrate, the protecting groups, which were not eliminated by the radio-active irradiation of the entire surface of the resist pattern, are eliminated completely. Accordingly, even in the case of using a chemical amplification resist in which protecting groups are not easily eliminated by the radio-active irradiation, it is possible to form a micropattern with excellent heat resistance which can sufficiently withstand dry etching at high temperature and hence the size of the pattern can be controlled with high precision.

In the method of forming micropatterns according to the present invention, in said heat-resistance improving step, the entire surface of said resist pattern can be irradiated with a radio-active ray without subjecting said semiconductor substrate to baking. This increases throughput compared with the case in which baking is conducted.

In the method of forming micropatterns according to the present invention, the radio-active ray used in said heat-resistance improving step is preferably a deep ultraviolet light. This enables the simple handling of the radio-active ray as well as the efficient elimination of the protecting groups.

In the method of forming micropatterns according to the present invention, the amount of energy of the radioactive ray used in said heat-resistance improving step is preferably 10000 mJ/cm² or less. This provides the resist pattern with improved heat resistance at the cost of less energy, so that the size variation of the resist pattern can surely be controlled.

In the method of forming micropatterns according to the present invention, said resist-pattern forming step may be for forming a resist pattern from said chemical amplification resist by exposing said chemical amplification to light or irradiating said chemical amplification resist with a radio-active ray, by heating said chemical amplification resist so as to diffuse an acid produced in said chemical amplification resist, and by developing said chemical amplification resist.

Thus, in the resist-pattern forming step, the chemical amplification resist is heated after exposed to light or irradiated with a radio-active ray, so that the acid produced in the chemical amplification resist by the exposure or radio-active irradiation can be diffused, thereby surely developing the chemical amplification resist.

Though Japanese Patent Publication No. 4-63535 proposes a post-bake method involving the radiation of a far ultraviolet ray, the method is disclosed and intended not with the use of a chemical amplification resist but with the use of a novolak-type resist, so that it is completely different from the method of the present invention which utilizes a novel concept of eliminating the protecting groups in a chemical amplification resist in order to improve its heat resistance.

There is also disclosed the radiation of light along with heat treatment in Japanese Patent Publication No. 5-58650. However, the method is for accomplishing taper etching with a pattern using a main-chain-cutting resist (e.g. polymethylmethacrylate or polymethylisopropenylketone), so that it is completely different from the method of the present invention which utilizes a novel concept of eliminating the protecting groups in a chemical amplification resist in order to improve its heat resistance.

### BRIEF DESCRIPTION OF THE DRAWINGS

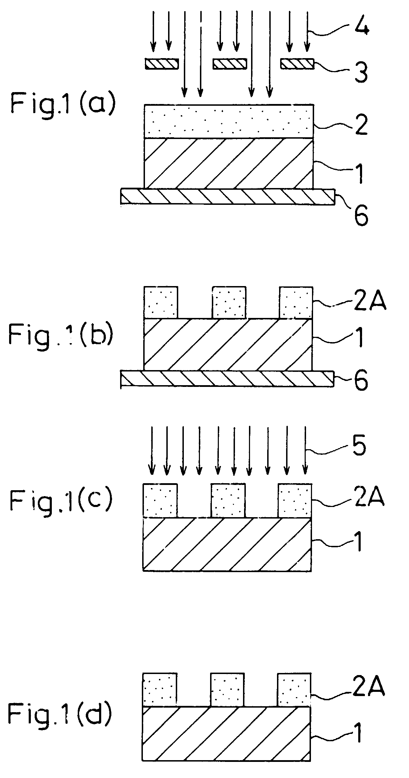

FIGS. 1 (a) to (d) are cross sections of a semiconductor substrate which show the step sequence of the method of forming micropatterns according to a first embodiment of the present invention;

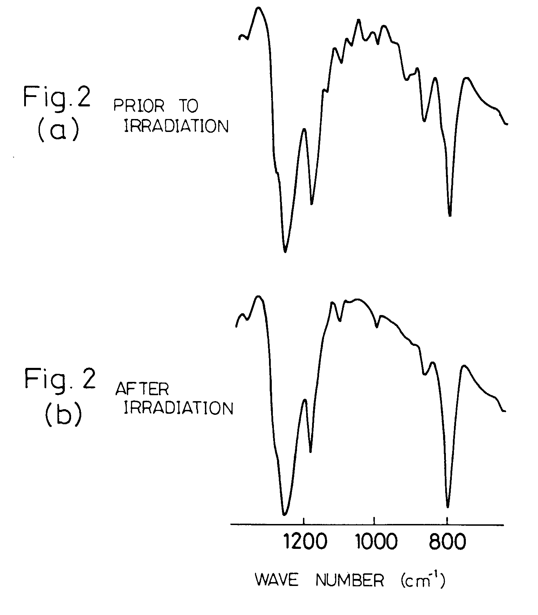

FIGS. 2(a) and 2(b) are graphs showing the transition of infrared spectra when a chemical amplification resist containing a derivative of polyvinyl phenol as its main component is irradiated with a radioactive ray: FIG. 2(a) shows the spectrum prior to the irradiation and FIG. 2(b) shows the spectrum after the irradiation;

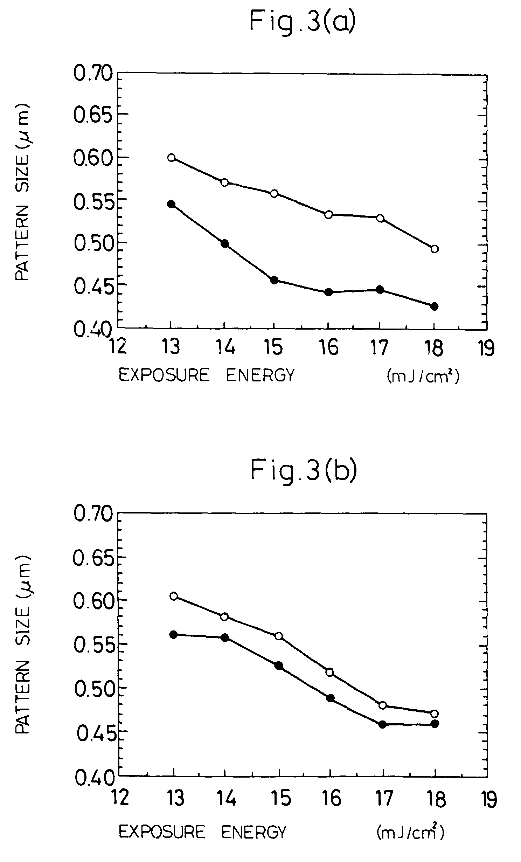

FIGS. 3(a) and 3(b) are graphs showing the size variation of a pattern with 0.5- µm lines and spaces in the case of using the chemical amplification resist containing a derivative of polyvinyl phenol as its main component: FIG. 3(a) shows the case in accordance with a conventional method and FIG. 3(b) shows the case in accordance with the method of the present invention;

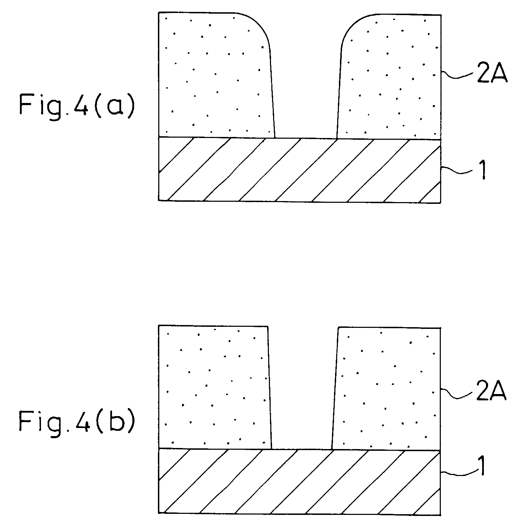

FIGS. 4(a) and 4(b) are views diagrammatically showing the sectional configuration of a 0.5- µm contact hole in the case of using the chemical amplification resist containing a derivative of polyvinyl phenol as its main component: FIG. 4(a) shows the case in accordance with the conventional method and FIG. 4(b) shows the case in accordance with the method of the present invention;

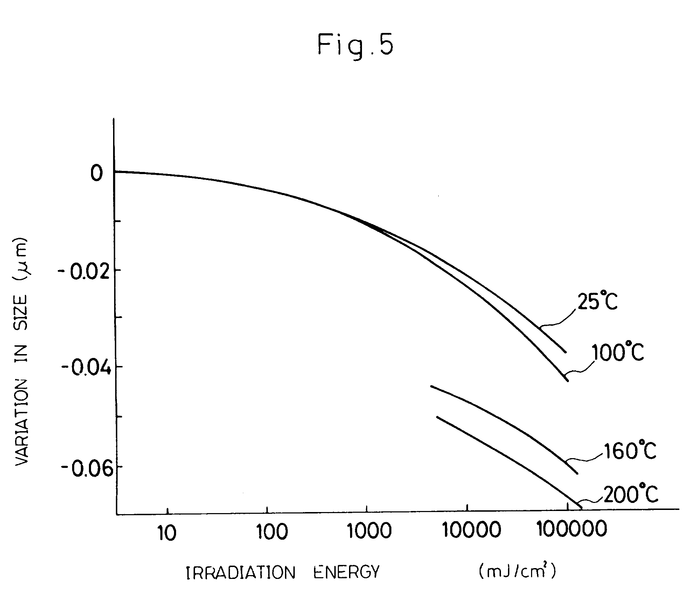

FIG. 5 is a graph showing the size variation of a resist pattern with 0.35- µm lines and spaces, which was formed from the chemical amplification resist containing a derivative of polyvinyl phenol as its main component, when a deep ultraviolet light was radiated by changing the temperature of the semiconductor substrate;
FIGS. 6(a) to 6(d) are cross sections of a semiconductor substrate showing the step sequence of the conventional method of forming micropatterns; and
FIG. 7 is a graph showing the sizes of a resist pattern formed according to the conventional method of forming micropatterns, which were measured after development and after a heat treatment, respectively.

### DETAILED DESCRIPTION OF THE PREFERRED EMBODIMENTS

According to the present invention, in forming a micropattern by using a chemical amplification resist containing, as its main component, a high-molecular compound which does not have sufficient heat resistance, the entire surface of a resist pattern obtained through development is irradiated with a radio-active ray, while maintaining the temperature of the semiconductor substrate in the range not higher than the glass transition point of the chemical amplification resist, so as to improve the heat resistance of the resist pattern by inducing the chemical change of the chemical amplification resist constituting the resist pattern. Consequently, the chemical amplification resist is provided with sufficient heat resistance, which is required in dry etching, without being cured, so that the foregoing disadvantage is overcome.

In forming the resist pattern, the chemical amplification resist, which was exposed to light or irradiated with a radio-active ray, may be heated in order to diffuse the acid produced in the chemical amplification resist.

In a process of improving the heat resistance, it is necessary to keep the temperature of the semiconductor substrate in the range not higher than the glass transition point of the chemical amplification resist so as to prevent the heat-transformation of the chemical amplification resist when the entire surface of the resist pattern is irradiated with a radio-active ray. As a means for maintaining the temperature of a semiconductor substrate in the range not higher than the glass transition point, cooling water and the like may be used to regulate the temperature of the semiconductor substrate.

The main polymer constituting the chemical amplification resist should be one in which a chemical change is induced by the radiation of a radio-active ray so that its glass transition point is raised by the chemical change. For example, a compound in which hydroxyl groups of polyvinyl phenol are substituted by alkoxy or like groups (a compound such as represented by [Formula 1]) has the foregoing properties. That is, the glass transition point of the main polymer, which is originally low because its phenol hydroxyl groups are substituted by protecting groups, is raised when the main polymer is changed to polyvinyl phenol under the radio-active irradiation. Consequently, a resist pattern with excellent heat resistance can easily be formed from a chemical amplification resist having only poor heat resistance. Moreover, since the temperature of the semiconductor substrate is kept in the range not higher than the glass transition point of the chemical amplification resist, curing does not occur of the resist pattern, thereby minimizing the variation in size of the resist pattern.

As a radio-active ray, any of a deep ultraviolet light, KrF eximer laser light, ArF eximer laser light, electron beam, X-ray, and the like can be used provided that it causes the foregoing chemical change. However, a radio-active ray of a shorter wavelength can efficiently cause the foregoing reaction. Among radio-active rays of shorter wavelengths, a deep ultraviolet light is the most effective in terms of its simple handling and its ability to cause the foregoing chemical reaction sufficiently.

FIGS. 2(a) and (b) show the transitions of infrared spectra when a chemical amplification resist containing a derivative of polyvinyl phenol as its main component is subjected to the radio-active irradiation according to the present invention: FIG. 2(a) shows the spectrum prior to the radio-active irradiation and FIG. 2(b) shows the spectrum after the radio-active irradiation. In the drawings, the abscissa represents the wave number of light and the ordinate represents light absorbency. By comparing FIG. 2(a) and FIG. 2(b), it will be understood that the absorption of light around 1120 cm⁻¹ resulting from the C-O-C stretching vibration of protecting groups, which was observed before the radio-active irradiation, is not observed any more after the radio-active irradiation. This proves that the reaction of eliminating protecting groups has proceeded.

Since the heat treatment for curing the chemical amplification resist is not necessary in the present invention, it is not required to radiate a radio-active ray with high power at high temperature, so that throughput is increased.

FIGS. 3(a) and 3(b) show the variation in size of a pattern with 0.5- µm lines and spaces in the case of using a chemical amplification resist containing a derivative of polyvinyl phenol as its main component: FIG. 3(a) shows the case in accordance with the conventional method and FIG. 3(b) shows the case in accordance with the present invention. In the drawings, hollow circles represent the size of the pattern prior to a heat treatment and solid circles represent the size of the pattern after the heat treatment. With the conventional method, the size of the pattern after the heat treatment was reduced by 10% or more of the initial size before the heat treatment. With the method of the present invention, however, the variation in size can be controlled as low as 5% or less.

FIGS. 4(a) and 4(b) are views diagrammatically showing the sectional configuration of 0.5 µm contact holes in the case of using a chemical amplification resist containing a derivative of polyvinyl phenol as its main component: FIG. 4(a) shows the case in accordance with the conventional method and FIG. 4(b) shows the case in accordance with the present invention. In a resist pattern for forming contact holes, in general, the remaining area of the resist is comparatively large, so that the reduction in volume of the resist will affect the resist pattern greatly. With the conventional method, the volume of the resist is reduced significantly, and the reduction is observed particularly in the upper portion of the resist which is not in direct contact with the semiconductor substrate, resulting in the Y-shaped edge profiles of the resist pattern. Such a deformed pattern may adversely affect the subsequent etching of the semiconductor substrate. With the method of the present invention, however, the edge profiles of the resist pattern remain vertical.

As described above, according to the present invention, micropatterns with precise dimensions and with excellent heat resistance can easily be formed.

In the process of forming a resist pattern, if a heat treatment is performed after the radio-active irradiation of the chemical amplification resist, the resist pattern with excellent heat resistance can be obtained, for the radio-active irradiation induces the elimination of undecomposed protecting groups contained in the chemical amplification resist and its glass transition point is thereby raised. The temperature for the heat treatment is not higher than the glass transition point of the chemical amplification resist after the radio-active irradiation.

FIG. 5 shows the variations in size of the resist patterns in the case where the resist patterns formed from a chemical amplification resist containing a derivative of polyvinyl phenol with 0.35 µm lines and spaces are irradiated with a deep ultraviolet light at different temperatures of 25° C, 100° C, 160° C, and 200° C, respectively.

The 0.35- µm design rule is expected to be dominant as the size of a pattern, and its permissible variation in practice is considered to be 10% or less. Consequently, when the temperature of the semiconductor substrate is not higher than the glass transition point of the chemical amplification resist, the maximum value of the irradiation energy amount is approximately 10000 mJ/cm², with which the size variation of the 0.35- µm pattern is 10% or less.

On the other hand, the minimum value of the irradiation energy amount is defined as a value which causes the foregoing chemical reaction, i.e., a value with which, when a resist film having an infinite area is exposed to or irradiated with light and then heated, if necessary, the thickness of the resist film becomes 0 after development.

In consideration of throughput, a radio-active ray having an illuminance of 20 mW/cm² or more is preferably used. For example, if there are used a radioactive ray having an illuminance of 200 mW/cm² and a resist film the thickness of which becomes 0 with the irradiation energy amount of 20 mJ/cm², the irradiation time is 0.1 second or more and 50 seconds or less.

Although the maximum and minimum values of the foregoing irradiation energy amount and the irradiation time were described with a deep ultraviolet light, they are similar even when other radioactive rays are used instead of a deep ultraviolet light. However, since the maximum and minimum values of the irradiation energy amount may be different depending on the composition of a chemical amplification resist and the type of a radio-active ray, they are not limited thereto.

### (Example 1)

Referring now to the drawings, a method of forming micropatterns according to a first embodiment of the present invention will be described below.

FIGS. 1(a) to 1(d) are cross sections of a semiconductor substrate showing the step sequence of the method of forming micropatterns according to the first embodiment of the present invention.

First, a chemical amplification resist composed of the following 1st Materials were prepared.

### (1st Materials)

| | |
|---|---|
| poly(p-tert-butoxycarbonyloxystyrene-p-hydroxystyrene) (weight-average molecular weight of approximately 9500, monomer unit ratio of approximately 1:1) | 6.0g |
| triphenylsulfonium hexafulorophosphate | 0.3g |
| diethylene glycol dimethyl ether | 13.7g |

Next, as shown in FIG. 1(a), the chemical amplification resist 2 composed of the foregoing 1st Materials was applied dropwise to the surface of a semiconductor substrate 1, followed by spin coating. Subsequently, the semiconductor substrate 1 was subjected to 1-minute baking on a hot plate 6 at a temperature of 90° C, so as to form a resist film 2 with the thickness of 1.0 µm. Then, the resulting resist film 2 was irradiated with KrF eximer laser light 4 through a mask 3.

Thereafter, the resist film 2 was sequentially subjected to 1-minute baking on the hot plate 6 at 100° C, as shown in FIG. 1(b), and to 1-minute development using an organic alkaline aqueous solution (2.38% tetramethylammoniumhydroxide aq.), thereby obtaining a resist pattern 2A.

Next, as shown in FIG. 1(c), the entire surface of the resulting resist pattern 2A was irradiated with a radio-active ray 5 containing as its main component a deep ultraviolet light of a wavelength of 200 to 600 nm with the power of 200 mW/cm² for 3 seconds, so as to eliminate t-butoxycarbonyl groups. During the irradiation, the temperature of the semiconductor substrate 1 was maintained at room temperature.

As a means for maintaining the temperature of the semiconductor substrate 1 at room temperature, a temperature regulator using cooling water was used. The glass transition point of the resist pattern 2A thus obtained is about 180 °C. Therefore, the resist pattern 2A was not deteriorated even after 10-minute baking at 160° C on the hot plate 6, and the resist pattern 2A was transferred onto the semiconductor substrate 1 with high fidelity as shown in FIG. 1(d).

The amount of size reduction of a 0.5- µm pattern after the development and radio-active irradiation was 0.01 µm, which was a sufficiently small value.

In place of the chemical amplification resist composed of the foregoing 1st Materials, chemical amplification resists composed of the following 2nd to 8th Materials were used, with the same satisfactory results obtained according to the method of radio-active irradiation mentioned above.

Thus, according to the first embodiment, a micropattern with excellent heat resistance was formed with ease, precision, and little size variation by using, as a deep-ultraviolet-light-sensitive resist, a positive resist containing as its main component a polymer or monomolecular compound in which at least a part of phenol hydroxyl groups are substituted by protecting groups that are easily eliminated by the action of an acid and by irradiating, after the development, the entire surface of the resist pattern with the deep ultraviolet light.

### (2nd Materials)

| | |
|---|---|
| poly(p-(1-ethoxyethoxy)styrene-p-hydroxystyrene) (weight-average molecular weight of approximately 10000, | |
| monomer unit ratio of approximately 1:1) | 6.0g |
| 2-cyclohexylcarbonyl-2-(p-toluenesulfonyl)propane | 0.3g |
| diethylene glycol dimethyl ether | 13.7g |

### (3rd Materials)

| | |
|---|---|
| poly p-vinylphenol (weight-average molecular weight of approximately 10000) | 5.0g |
| 2,2-bis(4-tetrahydropyranyloxyphenyl)propane | 1.5g |
| 2-cyclohexylcarbonyl-2-(p-toluenesulfonyl)propane | 0.3g |
| diethylene glycol diethyl ether | 13.2g |

### (4th Materials)

| | |
|---|---|
| poly(p-tert-butoxystyrene-p-hydroxystyrene) (weight-average molecular weight of approximately 10000, monomer unit ratio of approximately 1:1) | 6.0g |
| bis-cyclohexylsulfonyldiazomethane | 0.3g |
| diethylene glycol diethyl ether | 13.7g |

### (5th Materials)

| | |
|---|---|
| poly p-vinylphenol (weight-average molecular weight of approximately 20000) | 5.0g |
| 3,4-dihydro-4-(2,4-di-(1-ethoxyethoxy)phenyl)-7-(1-ethoxyethoxy)-2,2,4-trimethyl-2H-1-benzopyrane | 1.5g |
| 2-cyclohexylcarbonyl-2-(p-toluenesulfonyl)propane | 0.3g |
| 3-methoxy-methyl propionate | 13.2g |

### (6th Materials)

| | |
|---|---|
| poly(p-tetrahydropyranyloxystyrene-p-hydroxystyrene) (weight-average molecular weight of approximately 10000, monomer unit ratio of approximately 3:7) | 6.0g |
| 2-cyclohexylcarbonyl-2-(p-toluenesulfonyl)propane | 0.3g |
| 2-heptanone | 13.7g |

### (7th Materials)

| | |
|---|---|
| poly(p-(1-methoxy-1-methylethoxy)styrene-p-hydroxystyrene) (weight-average molecular weight of approximately 10000, monomer unit ratio of approximately 1:1) | 6.0g |
| p-toluenesulfonic acid 2,6-dinitrobenzyl | 0.1g |
| diethylene glycol dimethyl ether | 13.9g |

### (8th Materials)

| | |
|---|---|
| m-cresol novolak resin | 5.0g |
| p-tetrahydropyranyloxystyrene (weight-average molecular weight of approximately 10000) | 0.6g |
| triphenylsulfonium hexafluorophosphate | 0.1g |
| diethylene glycol dimethyl ether | 14.3g |

### (Example 2)

Below, the method of forming micropatterns according to a second embodiment of the present invention will be described.

Initially, the chemical amplification resist composed of the foregoing 2nd Materials was applied dropwise to the surface of a semiconductor substrate, followed by spin coating. Subsequently, the semiconductor substrate was subjected to 1-minute baking on a hot plate at a temperature of 90° C, so as to form a resist film with the thickness of 1.0 µm. Then, the resulting resist film was irradiated with an electron beam having an acceleration voltage of 50 keV.

Thereafter, the resist film was sequentially subjected to 1-minute baking on the hot plate at a temperature of 100° C and to 1-minute development using an organic alkaline aqueous solution, thereby obtaining a resist pattern.

Next, the entire surface of the resulting resist pattern was irradiated with a radio-active ray containing as its main component a deep ultraviolet light of a wavelength of 200 to 400 nm for 0.7 seconds, so as to eliminate 1-ethoxyethyl groups. During the irradiation, the temperature of the semiconductor substrate was maintained at 50° C.

The glass transition point of the resist pattern thus obtained is about 180° C, so that the resist pattern was not deteriorated even after baking on the hot plate at 160° C.

The amount of size reduction of a 0.5- µm pattern after the development and radio-active irradiation was 0.02 µm, which was a sufficiently small value.

In place of the chemical amplification resist composed of the foregoing 2nd Materials, chemical amplification resists composed of the 1st and 3rd to 8th Materials were used, with the same satisfactory results obtained according to the method of radio-active irradiation mentioned above.

Thus, according to the second embodiment, a micropattern with excellent heat resistance was formed with ease, precision, and little size variation by using, as a electron-beam resist, a positive resist containing as its main component a polymer or monomolecular compound in which at least a part of phenol hydroxyl groups are substituted by protecting groups that are easily eliminated by the action of an acid and by irradiating, after the development, the entire surface of the resist pattern with the deep ultraviolet light.

Although exposure was performed with the electron beam in the second embodiment, similar effects were obtained when an X-ray was used instead.

### (Example 3)

Below, the method of forming micropatterns according to a third embodiment of the present invention will be described.

Initially, the chemical amplification resist composed of the 4th Materials was applied dropwise to the surface of a semiconductor substrate, followed by spin coating. Subsequently, the semiconductor substrate was subjected to 1-minute baking on a hot plate at a temperature of 90° C, so as to form a resist film with the thickness of 1.0 µm. Then, the resulting resist film was irradiated with KrF eximer laser light through a mask.

Thereafter, the resist film was sequentially subjected to 1-minute baking on the hot plate at a temperature of 100° C and to 1-minute development using an organic alkaline aqueous solution, thereby obtaining a resist pattern.

Next, the entire surface of the resulting resist pattern was irradiated with a radio-active ray containing as its main component a deep ultraviolet light of a wavelength of 200 to 400 nm for 15 seconds, so as to eliminate tert-butyl groups. During the irradiation, the temperature of the semiconductor substrate was maintained at 100° C.

Next, 90-second baking was conducted on the hot plate at a temperature of 160° C, so as to decompose tert-butyl groups which are undecomposed.

The amount of size reduction of a 0.5- µm pattern after the development and heat treatment by baking was 0.02 µm, which was a sufficiently small value. The configuration of the resist pattern also remained excellent.

In place of the chemical amplification resist composed of the foregoing 4th Materials, chemical amplification resists composed of the 1st to 3rd and 5th to 8th Materials were used, with the same satisfactory results obtained according to the method of radio-active irradiation mentioned above.

Thus, according to the third embodiment, a micropattern with excellent heat resistance was formed with ease, precision, and little size variation by using, as a deep-ultraviolet-light-sensitive resist, a positive resist containing as its main component a polymer or monomolecular compound in which at least a part of phenol hydroxyl groups are substituted by protecting groups that are easily eliminated by the action of an acid, by irradiating, after the development, the entire surface of the resist pattern with the deep ultraviolet light, while maintaining the temperature of the semiconductor substrate in the range not higher than the glass transition point of the chemical amplification resist, and by further performing a heat treatment.

The heat treatment is not specified in particular. Any heat treatment can be used provided that it can decompose the protecting groups which are undecomposed.

Although exposure was performed with the KrF eximer laser light in the third embodiment, similar satisfactory results were obtained when an electron beam or X-ray was used instead.

## Claims

1. A method of forming micropatterns with heat resistance, comprising:
a resist coating step of coating the surface of a semiconductor substrate with a chemical amplification resist composed of a radiosensitive material containing, as its main component, a polymer or monomolecular compound in which at least a part of phenol hydroxyl groups are substituted by protecting groups that are easily eliminated by the action of an acid;
a resist-pattern forming step of forming a resist pattern from said chemical amplification resist by exposing said chemical amplification resist to light or irradiating said chemical amplification resist with a radio-active ray and by developing said chemical amplification resist; and
a heat-resistance improving step of improving the heat resistance of said resist pattern by irradiating the entire surface of said resist pattern with a radio-active ray, while maintaining the temperature of said semiconductor substrate in the range not higher than the glass transition point of said chemical amplification resist, so as to eliminate the protecting groups contained in said chemical amplification resist.

2. A method of forming micropatterns with heat resistance according to claim 1, wherein said heat-resistance improving step is for improving the heat resistance of said resist pattern by irradiating the entire surface of said resist pattern with a radio-active ray, while maintaining the temperature of said semiconductor substrate in the range not higher than the glass transition point of said chemical amplification resist, and by heating said semiconductor substrate.

3. A method of forming micropatterns with heat resistance according to claim 1, wherein, in said heat-resistance improving step, the entire surface of said resist pattern is irradiated with a radio-active ray without subjecting said semiconductor substrate to baking.

4. A method of forming micropatterns with heat resistance according to claim 1, wherein the radio-active ray used in said heat-resistance improving step is a deep ultraviolet light.

5. A method of forming micropatterns with heat resistance according to claim 1, wherein the amount of energy of the radio-active ray used in said heat-resistance improving step is 10000 mJ/cm² or less.

6. A method of forming micropatterns with heat resistance according to claim 1, wherein said resist-pattern forming step is for forming a resist pattern from said chemical amplification resist by exposing said chemical amplification to light or irradiating said chemical amplification resist with a radio-active ray, by heating said chemical amplification resist so as to diffuse an acid produced in said chemical amplification resist, and by developing said chemical amplification resist.

## Patentansprüche

1. Verfahren zur Erzeugung von wärmebeständigen Mikromustern (Mikrobildern), das umfaßt:
eine Resistmaterial-Beschichtungsstufe zum Beschichten der Oberfläche eines Halbleiter-Substrats mit einem chemischen Verstärkungs-Resistmaterial, bestehend aus einem strahlungsempfindlichen Material, das als seine Hauptkomponente ein Polymer oder eine monomolekulare Verbindung enthält, in dem (der) mindestens ein Teil der Phenol-Hydroxylgruppen durch Schutzgruppen substituiert sind, die unter der Einwirkung einer Säure leicht eliminiert werden;
eine Resist-Muster-Erzeugungsstufe zur Bildung eines Resist-Musters aus dem genannten chemischen Verstärkungs-Resistmaterial durch Belichten des genannten chemischen Verstärkungs-Resistmaterials mit Licht oder durch Bestrahlen des genannten chemischen Verstärkungs-Resistmaterials mit radioaktiver Strahlung und durch Entwickeln des genannten chemischen Verstärkungs-Resistmaterials; und
eine Wärmebeständigkeits-Verbesserungsstufe zur Verbesserung der Wärmebeständigkeit des genannten Resist-Musters durch Bestrahlen der gesamten Oberfläche des genannten Resist-Musters mit radioaktiver Strahlung, während die Temperatur des genannten Halbleiter-Substrats in einem Bereich gehalten wird, der nicht höher ist als der Glasumwandlungspunkt des genannten chemischen Verstärkungs-Resistmaterials, um auf diese Weise die in dem genannten chemischen Verstärkungs-Resistmaterial enthaltenen Schutzgruppen zu eliminieren.

2. Verfahren zur Erzeugung von wärmebeständigen Mikromustern nach Anspruch 1, bei dem die Wärmebeständigkeits-Verbesserungsstufe dazu dient, die Wärmebeständigkeit des genannten Resist-Musters zu verbessern durch Bestrahlen der gesamten Oberfläche des genannten Resist-Musters mit radioaktiver Strahlung, während die Temperatur des genannten Halbleiter-Substrats in einem Bereich gehalten wird, der nicht höher ist als der Glasumwandlungspunkt des genannten chemischen Verstärkungs-Resistmaterials und durch Erhitzen des genannten Halbleiter-Substrats.

3. Verfahren zur Erzeugung von wärmebeständigen Mikromustern nach Anspruch 1, bei dem in der genannten Wärmebeständigkeits-Verbesserungsstufe die gesamte Oberfläche des genannten Resist-Musters mit radioaktiver Strahlung bestrahlt wird, ohne daß das genannte Halbleiter-Substrat gebrannt wird.

4. Verfahren zur Erzeugung von wärmebeständigen Mikromustern nach Anspruch 1, bei dem die in der genannten Wärmebeständigkeits-Verbesserungsstufe verwendete radioaktive Strahlung tief-ultraviolettes Licht ist.

5. Verfahren zur Erzeugung von wärmebeständigen Mikromustern nach Anspruch 1, bei dem die Energiemenge der in der genannten Wärmebeständigkeits-Verbesserungsstufe verwendeten radioaktiven Strahlung 10 000 mJ/cm² oder weniger beträgt.

6. Verfahren zur Erzeugung von wärmebeständigen Mikromustern nach Anspruch 1, bei dem die genannte Resist-Muster-Erzeugungsstufe dazu dient, ein Resist-Muster aus dem genannten chemischen Verstärkungs-Resistmaterial zu bilden durch Belichten des genannten chemischen Verstärkungs-Resistmaterials mit Licht oder durch Bestrahlen des genannten chemischen Verstärkungs-Resistmaterials mit radioaktiver Strahlung, durch Erhitzen des chemischen Verstärkungs-Resistmaterials, um eine in dem genannten chemischen Verstärkungs-Resistmaterial gebildete Säure zu zersetzen, und durch Entwickeln des genannten chemischen Verstärkungs-Resistmaterials.

## Revendications

1. Procédé pour former des micromotifs résistants à la chaleur comprenant ;
une étape consistant à former une couche de résist sur la surface d'un substrat semi-conducteur, avec un résist à amplification chimique constitué d'un matériau radio-sensible contenant, en tant que composant principal, un composé polymère ou monomoléculaire dans lequel les groupes hydroxyle phénoliques sont substitués, au moins en partie, par des groupes protecteurs qui sont facilement éliminés par l'action d'un acide;
une étape consistant à former un motif de résist à partir de ladite couche de résist à amplification chimique en exposant ledit résist à amplification chimique à de la lumière ou en irradiant ledit résist à amplification chimique avec un rayonnement radioactif et en développant ledit résist à amplification chimique; et
une étape consistant à améliorer la résistance à la chaleur dudit motif de résist, en irradiant toute la surface dudit motif de résist avec un rayonnement radioactif, tout en maintenant la température dudit substrat semi-conducteur dans une plage ne dépassant pas la température de transition vitreuse dudit résist à amplification chimique, de manière à éliminer les groupes protecteurs contenus dans ledit résist à amplification chimique.

2. Procédé pour former des micromotifs résistants à la chaleur selon la revendication 1, dans lequel ladite étape d'amélioration de la résistance à la chaleur pour améliorer la résistance à la chaleur dudit motif de résist s'effectue en irradiant toute la surface dudit motif du résist avec un rayonnement radioactif, tout en maintenant la température dudit substrat semi-conducteur dans une plage ne dépassant pas la température de transition vitreuse dudit résist à amplification chimique et en chauffant ledit substrat semi-conducteur.

3. Procédé pour former des micromotifs résistants à la chaleur selon la revendication 1, dans lequel, dans ladite étape d'amélioration de la résistance à la chaleur, toute la surface dudit motif de résist est irradiée avec un rayonnement radioactif, sans soumettre ledit substrat semi-conducteur à une cuisson.

4. Procédé pour former des micromotifs résistants à la chaleur selon la revendication 1, dans lequel le rayonnement radioactif utilisé dans ladite étape d'amélioration de la résistance à la chaleur est constitué par une lumière correspondant à l'ultraviolet lointain.

5. Procédé pour former des micromotifs résistants à la chaleur selon la revendication 1, dans lequel la quantité d'énergie du rayonnement radioactif utilisé dans ladite étape d'amélioration de la résistance à la chaleur est de 10000 mJ/cm² ou moins.

6. Procédé pour former des micromotifs résistants à la chaleur selon la revendication 1, dans lequel l'étape de formation du motif de résist mise en oeuvre pour former un motif de résist, à partir dudit résist à amplification chimique, se fait en exposant ledit résist à amplification chimique à de la lumière ou en irradiant ledit résist à amplification chimique par un rayonnement radioactif, en chauffant ledit résist à amplification chimique de manière à faire diffuser un acide produit dans ledit résist à amplification chimique et en développant ledit résist à amplification chimique.
